# EUROPEAN PATENT SPECIFICATION

(11) **EP 0 510 656 B1**
(45) Date of publication and mention of the grant of the patent: **02.01.1997**
(21) Application number: 92106974.6
(22) Date of filing: 23.04.1992
(51) Int. Cl.: B01J 3/00, B01D 8/00, C23C 14/56, C23C 14/34

(54) **Evacuation system and method therefor**
Evakuierungssystem und -verfahren
Système et procédé d'évacuation

(30) Priority: 25.04.1991 JP 95147/91
(43) Date of publication of application: 28.10.1992
(73) Proprietor: HITACHI, LTD., Chiyoda-ku, Tokyo 100 (JP)
(72) Inventor: Takahashi, Kazue, Tsuchiura-shi (JP); Ueda, Shinjiro, Abiko-shi (JP); Edamura, Manabu, Niihari-gun, Ibaraki-ken (JP); Tamura, Naoyuki, Kudamatsu-shi (JP); Ichihashi, Kazuaki, Kudamatsu-shi (JP)
(74) Representative: Finck, Dieter, Dr.Ing.

(56) References cited:
- FR-A- 2 014 489
- FR-A- 2 380 070
- FR-A- 2 436 269
- US-A- 4 667 477
- US-A- 4 679 401
- US-A- 4 722 191

## Description

The present invention relates to an evacuation system comprising a main pump, an auxiliary pump disposed downstream of said main pump for operating said main pump, a cooling baffle disposed upstream of said main pump, a first pipeline for linking said cooling baffle with the main pump and with a vacuum chamber through a first valve, and a second pipeline for linking said auxiliary pump and said vacuum chamber through at least a second valve, wherein said cooling baffle has temperature control means for controlling its cooling temperature, and to a method for evacuating the evacuation system.

A well-known type of evacuation system of a high vacuum sputtering apparatus is generally comprised of a cryopump connected to a sputtering chamber through a valve and auxiliary pumps for performing evacuation to obtain a pressure under which the cryopump can be actuated. The cryopump cools a baffle to extremely low temperature, approximately 20K (absolute temperature), by using a helium refrigerator, and absorbs and exhausts gas molecules. Since the baffle is cooled to an extremely low temperature, the cryopump is excellent in exhaust ability with respect to, particularly, water. Furthermore, since the cryopump is of a storage type, even if the sputtering apparatus is stopped due to some accident, there is little influence on the outside. Therefore the cryopump is widely used in a sputtering apparatus and so on. However, the storage type pump is required to be periodically regenerated after the exhaust is performed to more than a predetermined extent. Furthermore, since such a cryopump also has an evacuation ability with respect to argon, it is necessary to control the amount of exhausted argon gas by a valve operation or the like in a sputtering filming apparatus using argon gas.

A cold head for cooling a baffle to approximately 150K by using a coolant is generally used to lower the pressure in a process chamber merely by increasing the exhaust amount of water molecules; or used as a cold trap to prevent oil molecules from flowing backward in an oil diffusion pump. In such cases, the cold head is connected to the process chamber through a valve, and a main pump is directly connected to the downstream side of the cold head.

In a conventional evacuation apparatus, as described above, the pumping speed with respect to gas molecules including water is made as high as possible in order to shorten the time required for continuing the exhaust to obtain a desired pressure. However, since there is a limit to the pumping speed of a vacuum pump and a storage type pump such as a cryopump needs regeneration operations, the time which does not contribute to production is necessary in a semiconductor manufacturing apparatus such as a sputtering apparatus. The semiconductor manufacturing apparatus is required to restrict such loss of time.

In order to meet the above request, one apparatus removes the loss of time arising from the warm-up and stop of a cooling source by switching the temperature of a coolant of a cold trap in a short time.

Such a kind of apparatus is disclosed in, for example, "A User's Guide to Vacuum Technology", John F. O'Hanlon.

The FR-A-2 380 070 discloses an evacuation system comprising a main pump, an auxiliary pump disposed downstream of said main pump for operating said main pump, a cooling baffle, disposed upstream of said main pump, a first pipeline, for linking said cooling baffle with said main pump and with a vacuum chamber through a first valve, and a second pipeline for linking said auxiliary pump and said vacuum chamber through a second valve. The main pump according to the FR-A-2 380 070 is a diffusion pump. Therefore, the main purpose of the cooling baffle coupled with this diffusion pump is to prevent back diffusion of the jet medium particles into the vacuum chamber.

The FR-A-2 436 269 discloses a turbomolecular pump coupled upstream with a cooling portion and the US-A-4 679 401 discloses a two-stage cryopump.

Use of a diffusion pump/cooling baffle combination, a turbomolecular pump/cooling portion combination or a two-stage cryopump in an evacuation arrangement as disclosed in the FR-A-2 380 070 leads to a blocking up of the cooling part by condensed gases after a certain time of operation.

The object of the present invention is to provide an evacuation system comprising a cooling baffle and a method for evacuating this evacuation system which are suited to prolong the operation time of the cooling baffle.

According to the invention this object is achieved by providing an evacuation system comprising a main pump, an auxiliary pump disposed downstream of said main pump for operating said main pump, a cooling baffle disposed upstream of said main pump, a first pipeline for linking said cooling baffle with the main pump and with a vacuum chamber through a first valve, and a second pipeline for linking said auxiliary pump and said vacuum chamber through at least a second valve, wherein said cooling baffle has temperature control means for controlling its cooling temperature, wherein a third valve is interposed in said first pipeline between said main pump and said cooling baffle, wherein a third pipeline comprising a fourth valve is connected to said first pipeline between said third valve and said main pump and to said vacuum chamber, and wherein said main pump is a turbomolecular pump, and by providing a method for evacuating this evacuation system according to claim 8.

The evacuation system according to the invention enables an operator to evacuate the vacuum chamber within three steps. In the first step only the auxiliary pump is operably connected to the vacuum chamber. In the second step the turbomolecular pump is additionally switched into the evacuation path, and only in the third step also the cooling baffle is switched into the evacuation path. In such a way it is ensured that the gas pressure inside the vacuum chamber is lower when the cooling baffle is switched into the evacuation path compared with the corresponding pressure in the prior art arrangement according to the FR-A-2 380 070, because, according to this prior art arrangement, the main pump and the cooling baffle have to be concurrently switched into the evacuation path. A lower starting pressure for the effective operation of the cooling baffle, however, results in a lower amount of condensed gasses inside the cooling baffle and therefore in a longer operation time of the cooling baffle.

In a preferred embodiment the evacuation system according to the invention comprises a pipeline system for introducing and returning a medium into said vacuum chamber to heat and/or cool said vacuum chamber which is mounted and formed with at least one switch valve for switching a heating medium and a cooling medium to be introduced. So the vacuum chamber can be heated for outgassing the walls and actively cooled after the baking process. The possibility of actively cooling the vacuum chamber after baking results in cool-down times which are shorter compared with the cool-down times during usual passive self-cooling of the vacuum chamber.

In another preferred embodiment of the evacuation system according to the invention the vacuum chamber is provided with means for heating said vacuum chamber and with an inlet tube for introducing a cooling medium to cool said vacuum chamber.

Preferably a leakage valve is connected to said vacuum chamber, and a tube connected to said leakage valve is cooled by a cooling medium of said cooling baffle. When the vacuum chamber is opened only through the cooled leakage valve, the moisture content of leakage gas is reduced to a great extent, and water molecules are thereby restrained from being absorbed on the inner wall of the vacuum chamber during the opening. This also keeps the cooling baffle from being blocked up fast during the following evacuation of the vacuum chamber.

Further preferred embodiments of the evacuation system are subjects of claims 5 to 7. Further corresponding evacuation methods are subjects of claims 9 to 13.

The invention is further illustrated with the aid of the accompanying drawings in which
- Fig. 1: is a schematic view of an evacuation system;
- Fig. 2: is a diagram showing the vapor pressures of argon and water;
- Fig. 3: is a schematic view of a system according to another embodiment of the present invention;
- Fig. 4: is a schematic view of a system according to a further embodiment of the present invention; and
- Fig. 5: is a schematic view of a system according to a still further embodiment of the present invention.

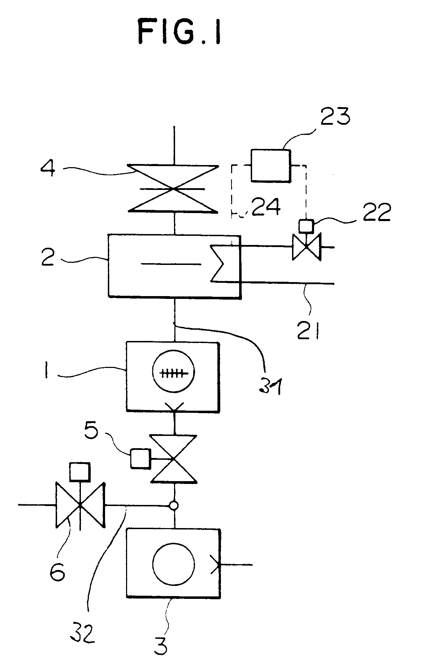

Fig. 1 shows an embodiment of an evacuation system provided as the base of the present invention. A turbo-molecular pump 1 serving as a main pump is connected by a first pipeline 31 through a cooling baffle 2 with a vacuum chamber (not shown) which is a container to be evacuated, and an auxiliary pump 3 through a valve 5. An upstream valve 4 disposed upstream of the cooling baffle 2 in the first pipeline 31 is connected to the vacuum chamber. As the upstream valve 4, a gate valve or the like having a great conductance is preferable in order to prevent the pumping speed from decreasing. A valve 6 is connected to an inlet of the auxiliary pump 3 and to the vacuum chamber (not shown) by a second pipeline 32, only a part of which is shown.

A coolant introducing pipe 21 for cooling the cooling baffle 2 has a control valve 22 for controlling the cooling temperature of the cooling baffle 2 by controlling the flow rate of a cooling medium. The degree of opening of the control valve 22 is controlled by a control device 23 in response to a signal from a temperature detector 24 for detecting the temperature of the cooling baffle 2. Although not shown, the cooling temperature of the cooling baffle 2 may be controlled by making the flow rate of the cooling medium constant and controlling the heating amount of a heating means mounted in the cooling baffle 2.

The exhaust process of a high-speed exhaust system using the evacuation system shown in Fig. 1 will now be described.

While the vacuum chamber is communicated with the air, the upstream valve 4 and the valve 5 are closed, and the turbo-molecular pump 1 and the cooling baffle 2 are in the rated operational state. In this state, the valve 6 is opened and the operation of the auxiliary pump 3 is started. When the pressure in the vacuum chamber becomes low enough to perform exhaust by the turbo-molecular pump 1, the valve 6 is closed and the valve 5 and the upstream valve 4 are opened. Thereby, the exhaust is continued to form a low vacuum region to medium and high vacuum regions. Since the exhaust ability of the cooling baffle 2 with respect to, particularly, water is increased, water serving as the main ingredient gas in the middle to high vacuum regions is exhausted at high speed.

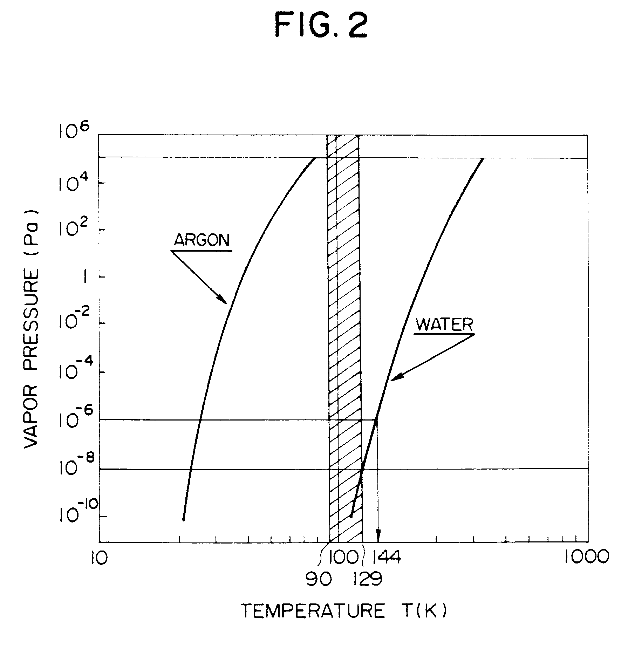

In a sputtering apparatus using argon gas, the temperature of the cooling baffle 2 is set at 90K to 144K. In order to explain the reason for the setting, vapor pressure curves with respect to argon and water are shown in Fig. 2. The boiling point of argon is 87.26K, and argon is vaporized above a temperature of 90K. Although it is needless to say that, although argon is absorbed on a baffle of the cooling baffle 2 at 90K, the amount of absorbed argon is less than that of a case in which the cooling baffle 2 is cooled to a liquid nitrogen temperature (77K). Since a satisfactory vapor pressure of water is 10⁻⁶Pa, the cooling baffle 2 is cooled to 144K, judging from Fig. 2. In other words, a state in which water is sufficiently exhausted and argon is not exhausted is formed by keeping the temperature of the cooling baffle 2 in the shaded portion shown in Fig. 2. Since argon is exhausted by the turbo-molecular pump 1 serving as a main pump, it is not necessary to regenerate the cooling baffle 2 in the same manner as when a cryopump is regenerated. Therefore, the time is not lost by the regeneration of the cooling baffle 2, and thus a long operation time can be taken.

If the exhaust by the auxiliary pump 3 is switched to the exhaust by the turbo-molecular pump 1 and a very rapid change arises in pressure, a wide pressure range or compound turbo-molecular pump is used as the turbo-molecular pump 1 in order to prevent the turbo-molecular pump 1 from being damaged. Since the wide pressure range turbo-molecular pump can operate even in a high pressure region, reliability is further increased.

A time t when exhaustion is performed from the atmospheric pressure P₀ to P of 13,3 Pa (0.1 Torr) at a pumping speed S (1000ℓ/min.) by the auxiliary pump 3 is obtained from the following expression when a capacity V of the chamber is 100ℓ:$\text{t =} \frac{\text{V}}{\text{S}} \text{· ln(} \frac{{\text{P}}_{\text{0}}}{\text{P}} \text{)} \text{= 2.3 ·} \frac{\text{V}}{\text{S}} \text{· log(} \frac{{\text{P}}_{\text{0}}}{\text{P}} \text{)} \text{= 54(s)}$

In other words, since 13,3 Pa (0.1 Torr) is obtained within approximately 1 minute, the above problem can be solved by using a proper pumping speed of the auxiliary pump 3 and a proper type of the main pump 1.

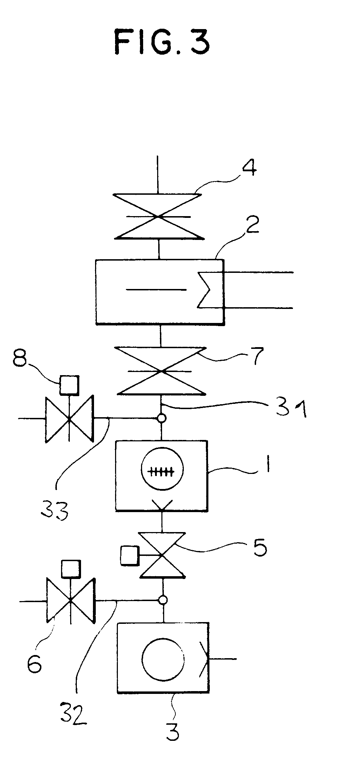

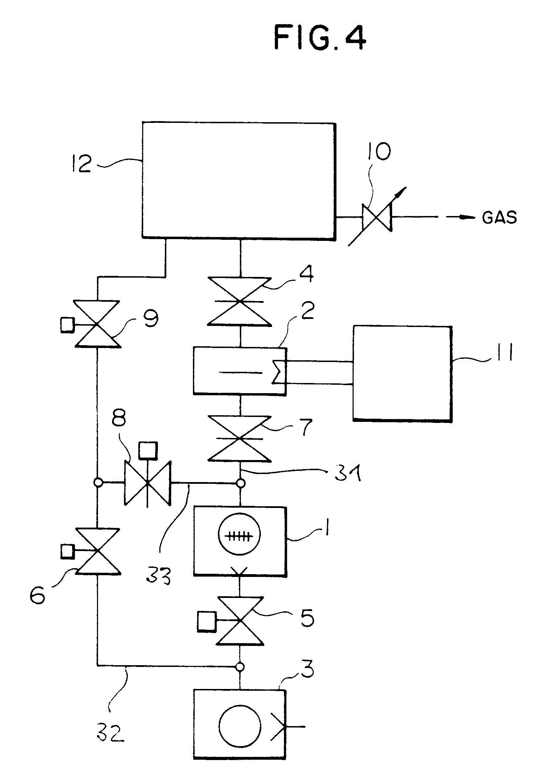

Another embodiment of the present invention will now be described with reference to Figs. 3 and 4.

In the embodiment of Fig. 3 a downstream valve 7 is interposed between the main pump 1 and the cooling baffle 2 in the first pipeline 31. Further, a third pipeline 33 with a valve 8 diverges from the inlet of the main pump 1, which third pipeline 33 is connected to the vacuum chamber (not shown). As upstream valve 4 and downstream valve 7, a gate valve having a great conductance is preferable in order to prevent the reduction of pumping speed.

Referring to Fig. 4, the system shown in Fig. 3 is connected to a vacuum chamber 12 by the first pipeline 31 at the upstream valve 4. The second pipeline 32 serving to perform exhaust by an auxiliary pump 3 from the air until a pressure capable of operating the main pump 1 is obtained is connected to the vacuum chamber 12 through a valve 9. The third pipeline 33 is connected to the second pipeline 32 between the valve 9 and the valve 6. The vacuum chamber 12 is provided with an additional pipe including an additional valve 10, preferably a leakage valve or a check valve. 11 represents control means as shown in Fig. 1, for example.

The high speed exhaust system shown in Fig. 4 using the evacuation system will be explained hereinafter. Exhaust processes after the vacuum chamber is exposed to the air for maintenance and so on will be described.

The upstream valve 4, the downstream valve 7, the valve 5 and the valve 8 are closed. The turbo-molecular pump 1 and the cooling baffle 2 are put into the rated operational state beforehand. In this state, the valve 6 and the valve 9 are opened and the operation of the auxiliary pump 3 is started. When the pressure in the vacuum chamber 12 becomes low enough to perform exhaust by the turbo-molecular pump 1, the valve 6 is closed and the valves 5 and 8 are opened. Thereby the exhaust is conducted from a low vacuum region to medium and high vacuum regions. Then, the upstream valve 4 and the downstream valve 7 are opened and the valves 8 and 9 are closed. Since the exhaust ability of the cooling baffle 2 is thereby added and, in particular, the exhaust ability with respect to water is increased, water as the main residual gas in the medium and high vacuum regions is exhausted at high speed.

In a sputtering apparatus using argon gas, the temperature of the cooling baffle 2 is set at 90K to 144K as described above. If an ultra-high vacuum is formed and then gas, such as argon, is supplied, it is possible in this embodiment to avoid the route on the side of the cooling baffle 2. In other words, the argon gas can be exhausted in sputtering by closing the upstream valve 4 and the downstream valve 7 and by opening the valves 8 and 9 without using the cooling baffle 2. In such a case, it is effective to use a wide pressure range type turbo-molecular pump which is able to be used in a high pressure region as the main pump 1.

If the exhaustion by the auxiliary pump 3 is switched to the exhaust by the turbo-molecular pump 1 and a very rapid change arises in pressure, in order to prevent the turbo-molecular pump 1 from being damaged, two valves 8 are mounted in parallel, one of the valves 8 is used as a pipeline with an orifice and first opened, and then the other valve is opened. Furthermore, as described above, the same effect is obtained when the main pump 1 is a wide pressure range type turbo-molecular pump.

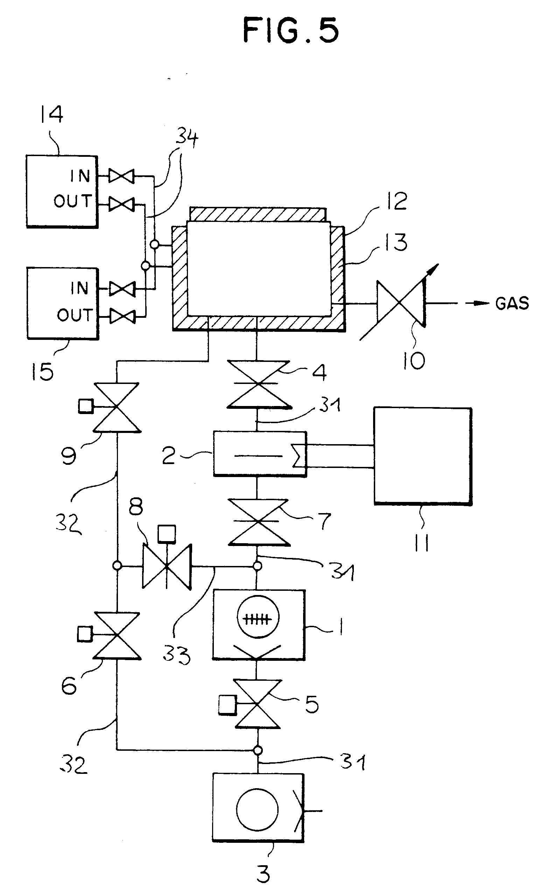

Although the above embodiment can shorten the pumping time, a method of further shortening the time will now be described. In the above embodiment, outgassing from the vacuum chamber 12 is not particularly taken into consideration. The amount of gas desorbed from the vacuum chamber 12 is generally decreased proportional to a reciprocal number of time. It is effective to accelerate the outgassing so as to shorten the pumping time. For example, the amount of desorbed gas is increased by heating the vacuum chamber 12. The example will be explained with reference to Fig. 5.

The evacuation system is the same as that in the above embodiment. A pipeline system 34 for circulating a heating medium is mounted to a vacuum chamber 12 so as to rapidly heat and cool the vacuum chamber 12. The vacuum chamber 12 shown in Fig. 5 has a double wall 13 through which the heating medium circulates around the vacuum chamber 12. A heating medium in a heating means 14 and a cooling medium in a cooling means 15 can be switched by operations of valves disposed in the pipeline system 34 as shown in Fig. 5. It is therefore possible to heat and cool the vacuum chamber 12 in a short time and to accelerate outgassing.

In baking of an ordinary vacuum device, a chamber is heated by a heater and cooled by natural heat radiation after baking. Therefore, cooling takes a longer time than heating.

According to another method of the present invention, baking (heating of the vacuum chamber 12) is performed by supplying electricity to a heater in the same manner as before, and the vacuum chamber 12 after baking can be rapidly cooled by circulating a cooling medium, for example, water. The amount of gas desorbed from the vacuum chamber 12 is decreased with cooling, and the pressure is lowered in a short time.

Although not shown in Fig. 5, the outgassing may be accelerated by using the outgassing method using discharge cleaning and radiation of ultraviolet rays, infrared rays and so on and the outgassing method using radiation of microwaves, and the short-time cooling may be carried out in the method of the present invention. In this case, the same advantageous effect can be obtained.

Furthermore, although not described in the embodiments of the present invention, it is needless to say that leakage gas must be introduced through a cold trap or the like so as to include as little water as possible when the vacuum chamber 12 kept at a vacuum is opened to or communicated with the air so as to return the chamber to an atmosphere pressure state usually using N₂ gas.

## Claims

1. An evacuation system, comprising
- a main pump (1),
- an auxiliary pump (3) disposed downstream of said main pump (1) for operating said main pump (1),
- a cooling baffle (2) disposed upstream of said main pump (1),
- a first pipeline (31) for linking said cooling baffle (2) with the main pump (1) and with a vacuum chamber (12) through a first valve (4), and
- a second pipeline (32) for linking said auxiliary pump (3) and said vacuum chamber (12) through at least a second valve (6),
wherein said cooling baffle (2) has temperature control means (11) for controlling its cooling temperature, characterized in that
- a third valve (7) is interposed in said first pipeline (31) between said main pump (1) and said cooling baffle (2),
- a third pipeline (33) comprising a fourth valve (8) is connected to said first pipeline (31) between said third valve (7) and said main pump (1) and to said vacuum chamber (12), and
- said main pump (1) is a turbomolecular pump.

2. An evacuation system according to claim 1, characterized in that a pipeline system (34) for introducing and returning a medium into said vacuum chamber (12) to heat and/or cool said vacuum chamber (12) is mounted and formed with at least one switch valve for switching a heating medium (14) and a cooling medium (15) to be introduced.

3. An evacuation system according to claim 1, characterized in that said vacuum chamber (12) is provided with means for heating said vacuum chamber (12) and an inlet tube for introducing a cooling medium to cool said vacuum chamber (12).

4. An evacuation system according to any of the preceding claims, wherein a leakage valve (10) is connected to said vacuum chamber, and a tube connected to said leakage valve (10) is cooled by a cooling medium of said cooling baffle (2).

5. An evacuation system according to any of the preceding claims, characterized in that
- said second pipeline (32) comprises a fifth valve (9) between said second valve (6) and said vacuum chamber (12), and
- said third pipeline (33) with the fourth valve (8) is connected to said vacuum chamber (12) through a connection with said second pipeline (32) between said second valve (6) and said fifth valve (9).

6. An evacuation system according to any of the preceding claims, characterized in that a fourth pipeline with a sixth valve is provided in parallel arrangement to the third pipeline (33), which fourth pipeline and third pipeline (33) are both connected with the first pipeline (31) between said third valve (7) and said turbomolecular pump (1) and with the second pipeline (32) upstream of said second valve (6).

7. An evacuation system according to any of the preceding claims, characterized in that a seventh valve (5) is interposed in said first pipeline (31) between said turbomolecular pump (1) and the link with said second pipeline (32).

8. A method for evacuating an evacuation system according to any of the claims 1 to 4 comprising the steps of
- operating the auxiliary pump (3), the turbomolecular pump (1), and the cooling baffle (2) with opened second valve (6), closed first valve (4), closed third valve (7), and closed fourth valve (8),
- operating the auxiliary pump (3), the turbomolecular pump (1), and the cooling baffle (2) with opened fourth valve (8), closed first valve (4), closed second valve (6), and closed third valve (7), and
- operating the auxiliary pump (3), the turbomolecular pump (1), and the cooling baffle (2) with opened first valve (4), opened third valve (7), closed second valve (6), and closed fourth valve (8).

9. A method for evacuating an evacuation system according to claim 5 comprising the steps of
- operating the auxiliary pump (3), the turbomolecular pump (1), and the cooling baffle (2) with opened second valve (6), opened fifth valve (9), closed first valve (4), closed third valve (7), and closed fourth valve (8),
- operating the auxiliary pump (3), the turbomolecular pump (1), and the cooling baffle (2) with opened fourth valve (8), opened fifth valve (9), closed first valve (4), closed second valve (6), and closed third valve (7), and
- operating the auxiliary pump (3), the turbomolecular pump (1), and the cooling baffle (2) with opened first valve (4), opened third valve (7), closed second valve (6), closed fourth valve (8), and closed fifth valve (9).

10. A method for evacuating an evacuation system according to claim 6 comprising the steps of
- operating the auxiliary pump (3), the turbomolecular pump (1), and the cooling baffle (2) with opened second valve (6), opened fifth valve (9) if available, closed first valve (4), closed third valve (7), closed fourth valve (8), and closed sixth valve,
- operating the auxiliary pump (3), the turbomolecular pump (1), and the cooling baffle (2) with opened fourth valve (8), opened fifth valve (9) if available, closed first valve (4), closed second valve (6), closed third valve (7), and closed sixth valve,
- operating the auxiliary pump (3) and the turbomolecular pump (1) with opened fourth valve (8), opened fifth valve (9) if available, opened sixth valve, closed first valve (4), closed second valve (6), and closed third valve (7), and
- operating the auxiliary pump (3), the turbomolecular pump (1), and the cooling baffle (2) with opened first valve (4), opened third valve (7), closed second valve (6), closed fourth valve (8), closed fifth valve (9) if available, and closed sixth valve.

11. A method for evacuating an evacuation system according to claim 7 comprising the steps of
- operating the auxiliary pump (3), the turbomolecular pump (1), and the cooling baffle (2) with opened second valve (6), opened fifth valve (9) if available, closed first valve (4), closed third valve (7), closed fourth valve (8), closed sixth valve if available, and closed seventh valve (5),
- operating the auxiliary pump (3), the turbomolecular pump (1), and the cooling baffle (2) with opened fourth valve (8), opened fifth valve (9) if available, opened seventh valve (5), closed first valve (4), closed second valve (6), closed third valve (7), and closed sixth valve if available,
- operating the auxiliary pump (3) and the turbomolecular pump (1) with opened fourth valve (8), opened fifth valve (9) if available, opened sixth valve, opened seventh valve (5), closed first valve (4), closed second valve (6), and closed third valve (7), and
- operating the auxiliary pump (3), the turbomolecular pump (1), and the cooling baffle (2) with opened first valve (4), opened third valve (7), opened seventh valve (5), closed second valve (6), closed fourth valve (8), closed fifth valve (9) if available, and closed sixth valve if available.

12. An evacuation method according to any of the claims 8 to 11, wherein outgassing is conducted on said vacuum chamber (12) after the evacuation by said auxiliary pump (3), said turbomolecular pump (1) and said cooling baffle (2) is started, and then said vacuum chamber (12) is rapidly cooled.

13. An evacuation method according to any of the claims 8 to 12, wherein the operations of said cooling baffle (2) and said turbomolecular pump (1) are continued with closed first valve (4), closed fourth valve (8), closed third valve (7), closed sixth valve if available, and closed second valve (6) or closed seventh valve (5) if available, while said vacuum chamber (12) is communicated with the air through a leakage valve (10).

## Patentansprüche

1. Evakuiersystem
- mit einer Hauptpumpe (1),
- mit einer Hilfspumpe (3), die stromab von der Hauptpumpe (1) zum In-Betrieb-Setzen der Hauptpumpe (1) angeordnet ist,
- mit einer Kühlprallwand (2), die stromauf von der Hauptpumpe (1) angeordnet ist,
- mit einer ersten Rohrleitung (31) zum Verbinden der Kühlprallwand (2) mit der Hauptpumpe (1) und mit einer Vakuumkammer (12) über ein erstes Ventil (4) und
- mit einer zweiten Rohrleitung (32) zum Verbinden der Hilfspumpe (3) und der Vakuumkammer (12) über wenigstens ein zweites Ventil (6),
wobei die Kühlprallwand (2) eine Temperatursteuereinrichtung (11) zum Steuern ihrer Kühltemperatur aufweist, dadurch gekennzeichnet,
- daß ein drittes Ventil (7) in die erste Rohrleitung (31) zwischen der Hauptpumpe (1) und der Kühlprallwand (2) eingesetzt ist,
- daß eine dritte Rohrleitung (33) mit einem vierten Ventil (8) mit der ersten Rohrleitung (31) zwischen dem dritten Ventil (7) und der Hauptpumpe (1) und mit der Vakuumkammer (12) verbunden ist und
- daß die Hauptpumpe (1) eine Turbomolekularpumpe ist.

2. Evakuiersystem nach Anspruch 1, dadurch gekennzeichnet, daß ein Rohrleitungssystem (34) zum Einführen und Rückführen eines Mediums in die Vakuumkammer (12) zum Erwärmen und/oder Abkühlen der Vakuumkammer (12) vorgesehen und mit wenigstens einem Schaltventil zum Umschalten zwischen der Einführung eines Heizmediums (14) und eines Kühlmediums (15) versehen ist.

3. Evakuiersystem nach Anspruch 1, dadurch gekennzeichnet, daß die Vakuumkammer (12) mit einer Einrichtung zum Erwärmen der Vakuumkammer (12) und mit einem Einlaßrohr zum Einführen eines Kühlmediums zum Kühlen der Vakuumkammer (12) versehen ist.

4. Evakuiersystem nach einem der vorhergehenden Ansprüche, bei welchem ein Leckageventil (10) mit der Vakuumkammer verbunden ist und ein mit dem Leckageventil (10) verbundenes Rohr durch ein Kühlmedium der Kühlprallwand (2) gekühlt wird.

5. Evakuiersystem nach einem der vorhergehenden Ansprüche, dadurch gekennzeichnet,
- daß die zweite Rohrleitung (32) ein fünftes Ventil (9) zwischen dem zweiten Ventil (6) und der Vakuumkammer (12) aufweist und
- daß die dritte Rohrleitung (33) mit dem vierten Ventil (8) mit der Vakuumkammer (12) über eine Verbindung mit der zweiten Rohrleitung (32) zwischen dem zweiten Ventil (6) und dem fünften Ventil (9) verbunden ist.

6. Evakuiersystem nach einem der vorhergehenden Ansprüche, dadurch gekennzeichnet, daß eine vierte Rohrleitung mit einem sechsten Ventil in paralleler Anordnung zu der dritten Rohrleitung (33) vorgesehen ist, wobei sowohl die vierte Rohrleitung als auch die dritte Rohrleitung (33) mit der ersten Rohrleitung (31) zwischen dem dritten Ventil (7) und der Turbomolekularpumpe (1) und mit der zweiten Rohrleitung (32) stromauf von dem zweiten Ventil (6) verbunden sind.

7. Evakuiersystem nach einem der vorhergehenden Ansprüche, dadurch gekennzeichnet, daß ein siebtes Ventil (5) in die erste Rohrleitung (31) zwischen der Turbomolekularpumpe (1) und der Verbindung mit der zweiten Rohrleitung (32) eingesetzt ist.

8. Verfahren zum Evakuieren eines Evakuiersystems nach einem der Ansprüche 1 bis 4, welches die Schritte aufweist
- In-Betrieb-Setzen der Hilfspumpe (3), der Turbomolekularpumpe (1) und der Kühlprallwand (2) bei geöffnetem zweiten Ventil (6), geschlossenem ersten Ventil (4), geschlossenem dritten Ventil (7) und geschlossenem vierten Ventil (8),
- In-Betrieb-Setzen der Hilfspumpe (3), der Turbomolekularpumpe (1) und der Kühlprallwand (2) bei geöffnetem vierten Ventil (8), geschlossenem ersten Ventil (4), geschlossenem zweiten Ventil (6) und geschlossenem dritten Ventil (7), und
- In-Betrieb-Setzen der Hilfspumpe (3), der Turbomolekularpumpe (1) und der Kühlprallwand (2) bei geöffnetem ersten Ventil (4), geöffnetem dritten Ventil (7), geschlossenem zweiten Ventil (6) und geschlossenem vierten Ventil (8).

9. Verfahren zum Evakuieren eines Evakuiersystems nach Anspruch 5, welches die Schritte aufweist
- In-Betrieb-Setzen der Hilfspumpe (3), der Turbomolekularpumpe (1) und der Kühlprallwand (2) bei geöffnetem zweiten Ventil (6), geöffnetem fünften Ventil (9), geschlossenem ersten Ventil (4), geschlossenem dritten Ventil (7) und geschlossenem vierten Ventil (8),
- In-Betrieb-Setzen der Hilfspumpe (3), der Turbomolekularpumpe (1) und der Kühlprallwand (2) bei geöffnetem vierten Ventil (8), geöffnetem fünften Ventil (9), geschlossenem ersten Ventil (4), geschlossenem zweiten Ventil (6) und geschlossenem dritten Ventil (7), und
- In-Betrieb-Setzen der Hilfspumpe (3), der Turbomolekularpumpe (1) und der Kühlprallwand (2) bei geöffnetem ersten Ventil (4), geöffnetem dritten Ventil (7), geschlossenem zweiten Ventil (6), geschlossenem vierten Ventil (8) und geschlossenem fünften Ventil (9).

10. Verfahren zum Evakuieren eines Evakuiersystems nach Anspruch 6, welches die Schritte aufweist
- In-Betrieb-Setzen der Hilfspumpe (3), der Turbomolekularpumpe (1) und der Kühlprallwand (2) bei geöffnetem zweiten Ventil (6), geöffnetem fünften Ventil (9), falls es vorhanden ist, geschlossenem ersten Ventil (4), geschlossenem dritten Ventil (7), geschlossenem vierten Ventil (8) und geschlossenem sechsten Ventil,
- In-Betrieb-Setzen der Hilfspumpe (3), der Turbomolekularpumpe (1) und der Kühlprallwand (2) bei geöffnetem vierten Ventil (8), geöffnetem fünften Ventil (9), falls es vorhanden ist, geschlossenem ersten Ventil (4), geschlossenem zweiten Ventil (6), geschlossenem dritten Ventil (7) und geschlossenem sechsten Ventil,
- In-Betrieb-Setzen der Hilfspumpe (3) und der Turbomolekularpumpe (1) bei geöffnetem vierten Ventil (8), geöffnetem fünften Ventil (9), falls es vorhanden ist, geöffnetem sechsten Ventil, geschlossenem ersten Ventil (4), geschlossenem zweiten Ventil (6) und geschlossenem dritten Ventil (7) und
- In-Betrieb-Setzen der Hilfspumpe (3), der Turbomolekularpumpe (1) und der Kühlprallwand (2) bei geöffnetem ersten Ventil (4), geöffnetem dritten Ventil (7), geschlossenem zweiten Ventil (6), geschlossenem vierten Ventil (8), geschlossenem fünften Ventil (9), falls es vorhanden ist, und geschlossenem sechsten Ventil.

11. Verfahren zum Evakuieren eines Evakuiersystems nach Anspruch 7, welches die Schritte aufweist
- In-Betrieb-Setzen der Hilfspumpe (3), der Turbomolekularpumpe (1) und der Kühlprallwand (2) bei geöffnetem zweiten Ventil (6), geöffnetem fünften Ventil (9), falls es vorhanden ist, geschlossenem ersten Ventil (4), geschlossenem dritten Ventil (7), geschlossenem vierten Ventil (8), geschlossenem sechsten Ventil, falls es vorhanden ist, und geschlossenem siebten Ventil (5),
- In-Betrieb-Setzen der Hilfspumpe (3), der Turbomolekularpumpe (1) und der Kühlprallwand (2) bei geöffnetem vierten Ventil (8), geöffnetem fünften Ventil (9), falls es vorhanden ist, geöffnetem siebten Ventil (5), geschlossenem ersten Ventil (4), geschlossenem zweiten Ventil (6), geschlossenem dritten Ventil (7) und geschlossenem sechsten Ventil, falls es vorhanden ist,
- In-Betrieb-Setzen der Hilfspumpe (3) und der Turbomolekularpumpe (1) bei geöffnetem vierten Ventil (8), geöffnetem fünften Ventil (9), falls es vorhanden ist, geöffnetem sechsten Ventil, geöffnetem siebten Ventil (5), geschlossenem ersten Ventil (4), geschlossenem zweiten Ventil (6) und geschlossenem dritten Ventil (7), und
- In-Betrieb-Setzen der Hilfspumpe (3), der Turbomolekularpumpe (1) und der Kühlprallwand (2) bei geöffnetem ersten Ventil (4), geöffnetem dritten Ventil (7), geöffnetem siebten Ventil (5), geschlossenem zweiten Ventil (6), geschlossenem vierten Ventil (8), geschlossenem fünften Ventil (9), falls es vorhanden ist, und geschlossenem sechsten Ventil, falls es vorhanden ist.

12. Evakuierverfahren nach einem der Ansprüche 8 bis 11, bei welchem ein Ausgasen an der Vakuumkammer (12) nach dem Evakuieren durch die Hilfspumpe (3) ausgeführt wird, wobei die Turbomolekularpumpe (1) und die Kühlprallwand (2) angelaufen sind und dann die Vakuumkammer (12) schnell gekühlt wird.

13. Evakuierverfahren nach einem der Ansprüche 8 bis 12, bei welchem die Kühlprallwand (2) und die Turbomolekularpumpe (1) bei geschlossenem ersten Ventil (4), geschlossenem vierten Ventil (8), geschlossenem dritten Ventil (7), geschlossenem sechsten Ventil, falls es vorhanden ist, und geschlossenem zweiten Ventil (6) oder geschlossenem siebten Ventil (5), falls es vorhanden ist, weiter arbeiten gelassen werden, während die Vakuumkammer (12) mit der Luft durch ein Leckageventil (10) in Verbindung steht.

## Revendications

1. Système à faire le vide, comprenant
- une pompe principale (1),
- une pompe auxiliaire (3) disposée en aval de ladite pompe principale (1) pour faire fonctionner ladite pompe principale (1),
- une chicane de refroidissement (2) disposée en amont de ladite pompe principale (1),
- une première canalisation (31) pour relier ladite chicane de refroidissement (2) avec la pompe principale (1) et une chambre à vide (12) par l'intermédiaire d'une première soupape (4), et
- une seconde canalisation (32) pour relier ladite pompe auxiliaire (3) et ladite chambre à vide (12) par l'intermédiaire d'au moins une seconde soupape (6),
dans lequel ladite chicane de refroidissement (2) possède des moyens de commande de température (11) pour commander sa température de refroidissement,
caractérisé en ce que
- une troisième soupape (7) est intercalée, dans ladite première canalisation (31), entre ladite pompe principale (1) et ladite chicane de refroidissement (2),
- une troisième canalisation (33) comprenant une quatrième soupape (8) est raccordée à ladite première canalisation (31) entre ladite troisième soupape (7) et ladite pompe principale (1) et à ladite chambre à vide (12), et
- ladite pompe principale (1) est une pompe turbomoléculaire.

2. Système à faire le vide selon la revendication 1, caractérisé en ce qu'un système de canalisations (34) pour introduire et renvoyer un fluide dans ladite chambre à vide (12) pour chauffer et/ou refroidir ladite chambre à vide (12) est monté et est équipé d'au moins une soupape de commutation pour commuter un fluide de chauffage (14) et un fluide de refroidissement (15) devant être introduits.

3. Système à faire le vide selon la revendication 1, caractérisé en ce que ladite chambre à vide (12) est équipée de moyens pour chauffer ladite chambre à vide (12) et d'un tube d'entrée pour introduire un fluide de refroidissement pour refroidir ladite chambre à vide (12).

4. Système à faire le vide selon l'une quelconque des revendications précédentes, dans lequel une soupape de fuite (10) est raccordée à ladite chambre à vide, et un tube raccordé à ladite soupape de fuite (10) est refroidi par un fluide de refroidissement de ladite chicane de refroidissement (2).

5. Système à faire le vide selon l'une quelconque des revendications précédentes, caractérisé en ce que
- ladite seconde canalisation (32) comprend une cinquième soupape (9) entre ladite seconde soupape (6) et ladite chambre à vide (12), et
- ladite troisième canalisation (33) équipée de la quatrième soupape (8) est raccordée à ladite chambre à vide (12) par l'intermédiaire d'une liaison avec ladite seconde canalisation (32) entre ladite seconde soupape (6) et ladite cinquième soupape (9).

6. Système à faire le vide selon l'une quelconque des revendications précédentes, caractérisé en ce qu'une quatrième canalisation équipée d'une sixième soupape est prévue selon un montage en parallèle avec la troisième canalisation (33), la quatrième canalisation et la troisième canalisation (33) étant toutes deux raccordées à la première canalisation (31) entre ladite troisième soupape (7) et ladite pompe turbomoléculaire (1) et à la seconde canalisation (32) en amont de ladite seconde soupape (6).

7. Système à faire le vide selon l'une quelconque des revendications précédentes, caractérisé en ce qu'une septième soupape (5) est intercalée dans ladite première canalisation (31) entre ladite pompe turbomoléculaire (1) et la liaison avec ladite seconde canalisation (32).

8. Procédé pour faire le vide dans un système à faire le vide selon l'une quelconque des revendications 1 à 4 comprenant les étapes consistant à
- faire fonctionner la pompe auxiliaire (3), la pompe turbomoléculaire (1) et la chicane de refroidissement (2) avec la seconde soupape (6) ouverte, la première soupape (4) fermée et la troisième soupape (7) fermée et la quatrième soupape (8) fermée,
- faire fonctionner la pompe auxiliaire (3), la pompe turbomoléculaire (1) et la chicane de refroidissement (2) avec la quatrième soupape (8) ouverte, la première soupape (4) fermée, la seconde soupape (6) fermée et la troisième soupape (7) fermée, et
- faire fonctionner la pompe auxiliaire (3), la pompe turbomoléculaire (1) et la chicane de refroidissement (2) avec la première soupape (4) ouverte, la troisième soupape (7) ouverte, la seconde soupape (6) fermée et la quatrième soupape (8) fermée.

9. Procédé pour faire le vide dans un système à faire le vide selon la revendication 5, comprenant les étapes consistant à
- faire fonctionner la pompe auxiliaire (3), la pompe turbomoléculaire (1) et la chicane de refroidissement (2) avec la seconde soupape (6) ouverte, la cinquième soupape (9) ouverte, la première soupape (4) fermée, la troisième soupape (7) fermée et la quatrième soupape (8) fermée,
- faire fonctionner la pompe auxiliaire (3), la pompe turbomoléculaire (1) et la chicane de refroidissement (2) avec la quatrième soupape (8) ouverte, la cinquième soupape (9) ouverte, la première soupape (4) fermée, la seconde soupape (6) fermée et la troisième soupape (7) fermée, et
- faire fonctionner la pompe auxiliaire (3), la pompe turbomoléculaire (1) et la chicane de refroidissement (2) avec la première soupape (4) ouverte, la troisième soupape (7) ouverte, la seconde soupape (6) fermée, la quatrième soupape (8) fermée et la cinquième soupape (9) fermée.

10. Procédé pour faire le vide dans un système à faire le vide selon la revendication 6, comprenant les étapes consistant à
- faire fonctionner la pompe auxiliaire (3), la pompe turbomoléculaire (1) et la chicane de refroidissement (2) avec la seconde soupape (6) ouverte, la cinquième soupape (9) ouverte, si elle est disponible, la première soupape (4) fermée, la troisième soupape (7) fermée, la quatrième soupape (8) fermée et la sixième soupape fermée,
- faire fonctionner la pompe auxiliaire (3), la pompe turbomoléculaire (1) et la chicane de refroidissement (2) avec la quatrième soupape (8) ouverte, la cinquième soupape (9) ouverte, si elle est disponible, la première soupape (4) fermée, la seconde soupape (6) fermée, la troisième soupape (7) fermée et la sixième soupape fermée,
- faire fonctionner la pompe auxiliaire (3) et la pompe turbomoléculaire (1) avec la quatrième soupape (8) ouverte, la cinquième soupape (9) ouverte, si elle est disponible, la sixième soupape ouverte, la première soupape (4) fermée, la seconde soupape (6) fermée et la troisième soupape (7) fermée, et
- faire fonctionner la pompe auxiliaire (3), la pompe turbomoléculaire (1) et la chicane de refroidissement (2) avec la première soupape (4) ouverte, la troisième soupape (7) ouverte, la seconde soupape (6) fermée, la quatrième soupape (8) fermée, la cinquième soupape (9) fermée, si elle est disponible, et la sixième soupape fermée.

11. Procédé pour faire le vide dans un système à faire le vide selon la revendication 7, comprenant les étapes consistant à
- faire fonctionner la pompe auxiliaire (3), la pompe turbomoléculaire (1), et la chicane de refroidissement (2) avec la seconde soupape (6) ouverte, la cinquième soupape (9) ouverte, si elle est disponible, la première soupape (4) fermée, la troisième soupape (7) fermée, la quatrième soupape (8) fermée, la sixième soupape fermée si elle est disponible, et la septième soupape (5) fermée,
- faire fonctionner la pompe auxiliaire (3), la pompe turbomoléculaire (1) et la chicane de refroidissement (2) avec la quatrième soupape (8) ouverte, la cinquième soupape (9) ouverte, si elle est disponible, la septième soupape (5) ouverte, la première soupape (4) fermée, la seconde soupape (6) fermée, la troisième soupape (7) fermée et la sixième soupape fermée, si elle est disponible,
- faire fonctionner la pompe auxiliaire (3) et la pompe turbomoléculaire (1) avec la quatrième soupape (8) ouverte, la cinquième soupape (9) ouverte, si elle est disponible, la sixième soupape ouverte, la septième soupape (5) ouverte, la première soupape (4) fermée, la seconde soupape (6) fermée et la troisième soupape (7) fermée, et
- faire fonctionner la pompe auxiliaire (3), la pompe turbomoléculaire (1) et la chicane de refroidissement (2) avec la première soupape (4) ouverte, la troisième soupape (7) ouverte, la septième soupape (5) ouverte, la seconde soupape (6) fermée, la quatrième soupape (8) fermée, la cinquième soupape (9) fermée, si elle est disponible, et la sixième soupape fermée, si elle est disponible.

12. Procédé pour faire le vide selon l'une quelconque des revendications 10 à 11, selon lequel un dégazage est exécuté dans ladite chambre à vide (12) après démarrage de la formation de vide par ladite pompe auxiliaire (3), ladite pompe moléculaire (1) et ladite chicane de refroidissement (2), puis ladite chambre à vide (12) est refroidie rapidement.

13. Procédé pour faire le vide selon l'une quelconque des revendications 8 à 12, dans lequel les actionnements de ladite chicane de refroidissement (2) et de ladite pompe turbomoléculaire (1) sont poursuivis avec la première soupape (4) fermée, la quatrième soupape (8) fermée, la troisième soupape (7) fermée, la sixième soupape fermée, si elle est disponible, et la seconde soupape (6) fermée ou la septième soupape (5) fermée, si elle est disponible, tandis que ladite chambre à vide (12) communique avec l'air par l'intermédiaire d'une soupape de fuite (10).
